# EUROPEAN PATENT SPECIFICATION

(11) **EP 4 567 899 B1**
(45) Date of publication and mention of the grant of the patent: **21.10.2026**
(21) Application number: 23214717.3
(22) Date of filing: 06.12.2023
(51) Int. Cl.: H10D 30/00, H10D 30/01, H10D 30/67, H10D 62/13, H10D 64/23, H10D 84/83, H10D 84/01, H10D 84/03, H10D 88/00, H10W 20/41, H10D 30/69, H10D 62/822, H10D 84/85, H10W 20/00, B82Y 10/00

(54) **METHOD FOR FORMING A SEMICONDUCTOR DEVICE**
VERFAHREN ZUR HERSTELLUNG EINER HALBLEITERVORRICHTUNG
PROCÉDÉ DE FORMATION D'UN DISPOSITIF SEMI-CONDUCTEUR

(43) Date of publication of application: 11.06.2025
(73) Proprietor: IMEC VZW, 3001 Leuven (BE)
(72) Inventor: VELOSO, Anabela, 3001 Leuven (BE); LOO, Roger, 3000 Leuven (BE); ENEMAN, Geert, 3001 Heverlee (BE)
(74) Representative: Lind Edlund Kenamets Intellectual Property AB

(56) References cited:
- EP-A1- 4 156 294
- US-A1- 2019 221 649
- US-A1- 2020 035 560
- US-A1- 2021 343 639
- US-A1- 2021 399 099
- US-A1- 2022 069 117

## Description

### TECHNICAL FIELD

The present invention relates to a method for forming a semiconductor device.

### BACKGROUND

The use of high mobility channel materials has long attracted great interest in the semiconductor industry since high mobility channel materials have a bulk mobility exceeding that of Si which is the most commonly used channel material. For instance, Ge has a bulk mobility which is 4.4 times higher for holes and 2.4 times higher for electrons as compared to Si. Such high bulk mobility generally results in a high drivability with high on-state currents, ION, of for instance Ge FETs. However, such high mobility channel material devices typically suffer from significantly higher band-to-band-tunneling, BTBT e.g. owing from their small bandgap, and thus higher off-state leakage currents, IOFF. Hence, there is a need to be able to manufacture high mobility channel material devices which exhibit lower off-state leakage currents while still taking advantage of the high drivability, and thus high on-state currents.

US 2019/221649 A1 discloses techniques for backside source/drain (S/D) replacement for semiconductor devices with metallization on both sides (MOBS). The techniques described provide methods to recover or otherwise facilitate low contact resistance. In some cases, the techniques include forming sacrificial S/D material and a seed layer during frontside processing of a device layer including one or more transistor devices. The device layer can then be inverted and bonded to a host wafer. A backside reveal of the device layer can then be performed via grinding, etching, and/or CMP processes. The sacrificial S/D material can then be removed through backside S/D contact trenches using the seed layer as an etch stop, followed by the formation of relatively highly doped final S/D material grown from the seed layer.

US 2021/343639 A1 discloses an integrated circuit (IC) structure which includes a gate structure, a source epitaxial structure, a drain epitaxial structure, a front-side interconnection structure, a backside dielectric layer, an epitaxial regrowth layer, and a backside via. The source epitaxial structure and the drain epitaxial structure are respectively on opposite sides of the gate structure. The front-side interconnection structure is over a front-side of the source epitaxial structure and a front-side of the drain epitaxial structure. The backside dielectric layer is over a backside of the source epitaxial structure and a backside of the drain epitaxial structure. The epitaxial regrowth layer is on the backside of a first one of the source epitaxial structure and the drain epitaxial structure. The backside via extends through the backside dielectric layer and overlaps the epitaxial regrowth layer.

US 2021/399099 A1 discloses a semiconductor device structure which includes a source feature and a drain feature, at least one channel structure extending between the source feature and the drain feature, a gate structure wrapped around each of the at least one channel structure, a semiconductor layer over the gate structure, a dielectric layer over the semiconductor layer, a doped semiconductor feature extending through the semiconductor layer and the dielectric layer to be in contact with the source feature, a metal contact plug over the doped semiconductor feature, and a buried power rail disposed over the metal contact plug.

US 2022/069117 A1 discloses a semiconductor structure and a method of forming the same. In an embodiment, a semiconductor structure includes an epitaxial source feature and an epitaxial drain feature, a vertical stack of channel members disposed over a backside dielectric layer, the vertical stack of channel members extending between the epitaxial source feature and the epitaxial drain feature along a direction, a gate structure wrapping around each of the vertical stack of channel members, and a backside source contact disposed in the backside dielectric layer. The backside source contact includes a top portion adjacent the epitaxial source feature and a bottom portion away from the epitaxial source feature. The top portion and the bottom portion includes a step width change along the direction.
US 2020/0035560 A1 discloses a method for manufacturing an asymmetric device. In one embodiment, a first source/drain region and a second source/drain region are formed on a substrate. Portions of the substrate in a region corresponding to the first source/drain region are then removed so as to expose the first source/drain region. A back-side source/drain semiconductor is subsequently deposited on the exposed first source/drain region. The back-side source/drain semiconductor comprises a tip region, for example a lightly doped semiconductor. The first source/drain region functions as a source region, while the second source/drain region functions as a tipless drain region, thereby introducing asymmetry between the source and drain regions.

### SUMMARY

In light of the above, it is an object of the present invention to provide a method for forming a semiconductor device which mitigates at least some of the issues associated with high mobility channel material devices.

Hence, it is an object to provide a method for forming a semiconductor device which enables formation of a high mobility channel material semiconductor device with a reduced off-state leakage current.

Another object is to provide a method for forming a semiconductor device which enables formation of a high mobility channel material semiconductor device which has a high drivability, and hence a high on-state current, with a reduced off-state leakage current.

Another object is to provide a method for forming a semiconductor device which enables formation of a high mobility channel material semiconductor device with a reduced contact resistance.

Another object is to provide a method for forming a semiconductor device which requires fewer process steps.

Another object is to provide a method for forming a semiconductor device which is less complex.

Another object is to provide a method for forming a semiconductor device which is more cost-effective.

These and other objects may be achieved by a method for forming a semiconductor device in accordance with the independent claim. Embodiments of the present invention are defined in the dependent claims.

Hence, according to an aspect of the present invention, there is provided a method for forming a semiconductor device, comprising: performing frontside processing comprising forming a transistor structure on a frontside of a substrate, the transistor structure comprising a first source/drain body and a second source/drain body located in a first and a second source/drain region, respectively, and a channel structure between the first source/drain body and the second source/drain body, wherein the first source/drain body and the second source/drain body have a first doping concentration; subsequent to the frontside processing, performing backside processing comprising: exposing the first source/drain body from a backside of the substrate; and processing the first source/drain body to form, in the first source/drain region, a replacement source/drain body having a second doping concentration different from the first doping concentration, while not affecting the first doping concentration of the second source/drain body in the second source/drain region to form a non-uniform transistor structure with an asymmetric source drain doping, by; removing at least a major portion of the first source/drain body, to form a source/drain body cavity in the first source/drain region, and subsequently epitaxially growing doped source/drain material in the source/drain body cavity.

Thus, the present invention is based on the insight that by processing the first source/drain body to form a replacement source/drain body which has a different doping concentration than the second source/drain body, an asymmetric semiconductor device, i.e. a device with an asymmetric doping of the source/drain bodies, may be formed. In particular, an asymmetric high mobility channel material semiconductor device or high mobility device may be formed.

In this regard, in order to provide a high mobility device which offers high drivability and low off-state currents the device will typically have a high source doping, which allows for high on-state currents, while at the same time have low drain doping, which allows for low off-state leakage currents.

Further, the present method may allow for forming an asymmetric high mobility channel material semiconductor device or high mobility device while using fewer process steps as compared to traditional methods. More specifically, by processing the first source/drain body during the backside processing, which anyhow may involve accessing the first source/drain body for contacting with a backside power delivery network, the asymmetric doping may be provided without adding additional process steps during the frontside processing. Accordingly, the present method may be especially beneficial in fabrication of a semiconductor device comprising a backside power delivery network.

Furthermore, the present method may allow for forming an asymmetric high mobility channel material semiconductor device or high mobility device in a less complex way at a reduced cost.

The first source/drain body and the second source/drain body may be a source body and a drain body, respectively. Alternatively, the first source/drain body and the second source/drain body may be a drain body and a source body, respectively. This applies correspondingly to the first and second source/drain regions.

In practice, in a case where the first source/drain body and the first source/drain region is a source body and a source region, respectively, the present method enables forming an asymmetric device by increasing the doping concentration in the source region by forming the replacement source body with a higher doping concentration as compared to the concentration of the drain body.

Conversely, in practice, in a case where the first source/drain body and the first source/drain region is a drain body and a drain region, respectively, the present method enables forming an asymmetric device by decreasing the doping concentration in the drain region by forming the replacement drain body with a lower doping concentration as compared to the concentration of the source body.

Consequently, the present method enables fabrication of an asymmetric device by increasing or decreasing the doping concentration in the first source/drain region while not affecting the doping concentration in the second source/drain region.

The difference in doping concentrations between the replacement source/drain body and the second source/drain body is by the present method achieved by processing the first source/drain body to form, in the first source/drain region, a replacement source/drain body having a second doping concentration different from the first doping concentration. Thereby, an asymmetric transistor structure, i.e. a non-uniform transistor structure with asymmetric source drain doping is formed.

Thus, by forming the first source/drain body and the second source/drain body with a first doping concentration during frontside processing, and subsequently during backside processing, processing the first source/drain body to form a replacement source body having a second doping concentration different from the first doping concentration, the asymmetry of the formed semiconductor device may be tailored by tailoring the first and the second doping concentrations.

By "replacement source/drain body" is here meant a source/drain body having properties different from those of the first source/drain body which is formed during the frontside processing. In particular, the replacement source/drain body may have a higher doping concentration as compared to the first source/drain body formed during the frontside processing, or, the replacement source/drain body may have a lower doping concentration as compared to the first source/drain body formed during the frontside processing.

The replacement source/drain body may comprise material from the first source/drain body formed during the frontside processing and other material than the material of the first source/drain body formed during the frontside processing. According to unclaimed examples useful for understanding the invention, the replacement source/drain body may for example be formed by altering the first source/drain body formed during the frontside processing. According to unclaimed examples useful for understanding the invention, the replacement source/drain body may for example be formed by altering a portion of the first source/drain body formed during the frontside processing. According to the invention, the replacement source/drain body is formed by replacing at least a major portion of the first source/drain body formed during the frontside processing. The replacement source/drain body replaces the first source/drain body formed during the frontside processing.

According to some embodiments, processing the first source/drain body may comprise epitaxially growing doped source/drain material in the first source/drain region, which is advantageous in that the replacement source/drain body may be formed by epitaxial material with a higher or lower doping concentration as compared to the first source/drain body. The replacement source/drain body may be formed with a higher doping concentration as compared to the first source/drain body by epitaxially growing doped source/drain material having a doping concentration higher than the first doping concentration. In this way, the overall or average doping concentration of the replacement source/drain body may be increased relative to the first and second source/drain bodies. Alternatively, the replacement source/drain body may be formed with a lower doping concentration as compared to the first source/drain body by epitaxially growing doped source/drain material having a doping concentration lower than the first doping concentration. In this way, the overall or average doping concentration of the replacement source body may be decreased relative to the first and second source/drain bodies.

According to some embodiments, the doped source/drain material may be grown on an exposed surface of the first source/drain body, which is advantageous in that the first source/drain body may be at least partly preserved in the first source/drain region. This may facilitate the processing since less material of the first source/drain body needs to be removed.

According to the invention, processing the first source/drain body comprises; removing at least a major portion of the first source/drain body, to form a source/drain body cavity in the first source/drain region.
By removing at least a major portion of the first source/drain body a source/drain body cavity corresponding to a least a major portion of the first source/drain body is formed in the first source/drain region. By subsequently epitaxially growing the doped source/drain material in the source/drain body cavity the resulting replacement source/drain body is formed with the second doping concentration. The second doping concentration is provided in a greater part of the replacement source/drain body.

According to some embodiments, the first source/drain body may comprise a semiconductor liner provided at least at an interface between the first source/drain body and the channel structure, wherein the semiconductor liner is formed of a material different from a material of the first source/drain body, which is advantageous in that the liner may protect the channel structure during the backside processing. For instance, the liner may protect the channel structure while forming the source/drain body cavity. Furthermore, the liner may protect the channel structure during the frontside processing.

According to some embodiments, the at least a major portion of the first source/drain body may be removed using an etching process etching the material of the first source/drain body selective to the material of the semiconductor liner, which is advantageous in that the extension of the source/drain body cavity may be controlled by the presence of the liner. Further, the liner may prevent or counteract that the channel structure is affected by the etchants used for forming the source/drain body cavity.

According to some embodiments, exposing the first source/drain body may comprise thinning the substrate from the backside.

According to some embodiments, exposing the first source/drain body may comprise forming an opening in the substrate underneath the first source/drain body to expose the first source/drain body, wherein the first source/drain body is processed from the opening in the substrate.

According to some embodiments, forming the opening in the substrate may comprise thinning the substrate to expose a dummy contact plug provided underneath the first source/drain body, and removing the dummy contact plug to expose the first source/drain body.

According to some embodiments, the method may further comprise: subsequent to forming the opening in the substrate, forming an insulating liner covering the substrate and the exposed first source/drain body; and opening the insulating liner in the opening in the substrate to expose the first source/drain body, wherein the first source/drain body is processed from the opening in the insulating liner, which is advantageous in that the insulating liner may protect the substrate during the backside processing.

According to some embodiments, the doped source/drain material may be epitaxially grown via the opening in the insulating liner, which is advantageous in that the insulating liner may inhibit the doped source/drain material from growing at the substrate while being epitaxially grown via the opening in the insulating liner. The insulating liner may thus be used as an epitaxy mask inhibiting deposition of source/drain material in regions other than the first source/drain region.

According to some embodiments, the at least a major portion of the first source/drain body may be removed by etching from the opening in the insulating liner, which is advantageous in that the insulating liner may prevent or counteract that the substrate is affected by the etching. The insulating liner may thus be used as an etch mask when etching the first source/drain body.

According to some embodiments, exposing the first source/drain body may comprise: removing the substrate underneath the transistor structure to expose the first source/drain body and the second source/drain body; forming a bottom isolation layer covering the first source/drain body and the second source/drain body; and forming an opening in the bottom isolation layer to expose the first source/drain body; wherein the first source/drain body is processed from the opening in the bottom isolation layer, which is advantageous in that the bottom isolation layer may protect the transistor structure while processing the first source/drain body from the opening in the bottom isolation layer.

According to some embodiments, the opening in the bottom isolation layer may formed by removing a dummy contact plug provided underneath the first source/drain body, which is advantageous in that the opening in the bottom isolation layer may be formed in a self-aligned manner.

According to unclaimed examples useful for understanding the present invention, processing the first source/drain body may comprise increasing the doping concentration in the first source/drain body, and wherein increasing the doping concentration comprises: implanting dopants into the first source/drain body, and/or diffusing dopants into the first source/drain body. The doping concentration in the replacement source/drain body may hence be increased by selectively introducing dopants in the first source/drain body (but not the second source/drain body).

According to some embodiments, the method may further comprise: forming a source/drain contact on the replacement source/drain body, which is advantageous in that a reduced contact resistance may be achieved between the replacement source/drain body and the source/drain contact as compared to if the source/drain contact were to be formed on the first source/drain body.

According to some embodiments, the frontside processing may further comprise forming a source/drain contact on the second source/drain body.

According to some embodiments, the frontside processing may further comprise forming a gate stack on the channel structure.

According to some embodiments, the channel structure may comprise one or more layers of a Ge-comprising channel material.

According to some embodiments, the channel structure may comprise one or more layers of a SiGe-comprising channel material.

### BRIEF DESCRIPTION OF THE DRAWINGS

This and other aspects of the present invention will now be described in more detail, with reference to the appended drawings showing embodiments of the present invention.
Figs. 1-4 schematically shows a device structure at different stages of a method for forming a semiconductor structure.
Fig. 5 schematically shows how a replacement source/drain body may be formed according to unclaimed examples useful for understanding the present invention.
Figs. 6-8 schematically shows a device structure at different stages of a method for forming a semiconductor structure.
Fig. 9 schematically shows how a source/drain contact may be formed according to embodiments.
Figs. 10-13 schematically shows a device structure at different stages of a method for forming a semiconductor structure.
Fig. 14 schematically shows a device structure comprising a dummy contact plug.
Fig. 15 schematically shows a device structure in which the first source/drain body comprises a semiconductor liner.

### DETAILED DESCRIPTION

Hereafter follows a detailed description of various method embodiments for forming a semiconductor device. More specifically, the methods comprise, subsequent to the frontside processing, performing backside processing including processing a first source/drain (S/D) body to form, in a first S/D region, a replacement S/D body having a doping concentration different from the doping concentration of the first S/D body. The methods will be described with reference to the drawings.

The drawings are only schematic and the relative dimensions of some structures and layers may be exaggerated and not drawn to scale. Rather the dimensions may be adapted for illustrational clarity and to facilitate understanding. When present in the figures, the indicated axes X and Y consistently refer to a horizontal or lateral direction, and a vertical direction, respectively. As used herein, the terms "horizontal" and "lateral" refer to directions parallel to (a main surface of) a substrate on/from which the semiconductor device being formed. The term "vertical" refers to a direction parallel to a normal direction of (a main surface of) the substrate on/from which the semiconductor device being formed, i.e., transverse to the substrate. Further, the (positive) vertical direction refers to a direction which points out of what typically is regarded as a frontside of the substrate.

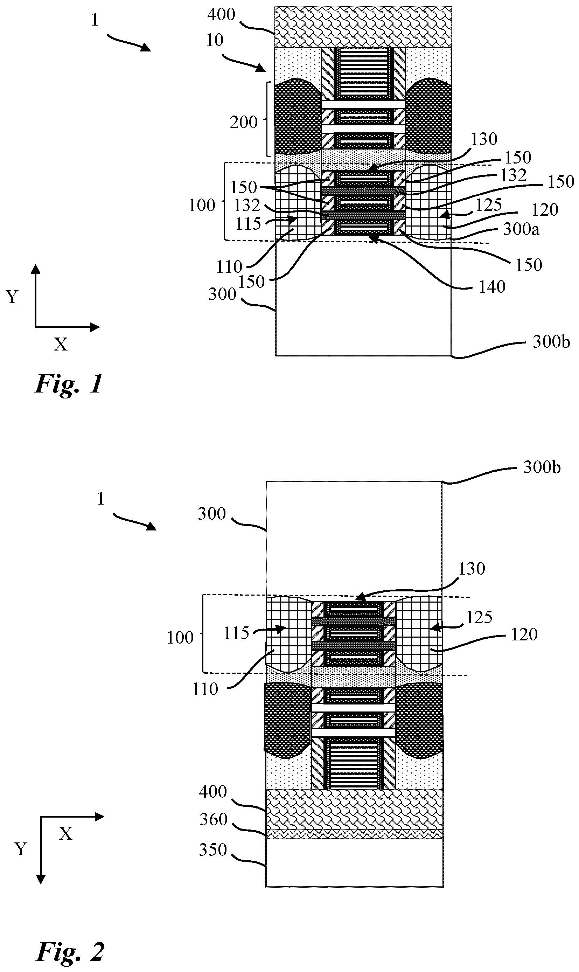

Initially it will be briefly described with reference to Fig. 1, a transistor structure 100, which may be formed by performing frontside processing. In Fig. 1, the transistor structure 100 forms part of a complementary field effect transistor (CFET) structure 10 which may be formed performing frontside processing. The CFET structure 10 forms part of the device structure 1 depicted in Fig. 1. Hence, the device structure 1 includes all elements and structures depicted in Fig. 1. In the following, the device structure 1 will be described at different stages of method embodiments while referring to the drawings. As is known in the art, a CFET typically comprises a PMOS transistor structure 100 and a NMOS transistor structure 200 vertically stacked on top of each other. In the following description, the transistor structure 100 located closest to the substrate 300 will be described although the transistor structure 200 will also be illustrated throughout the drawings for illustrative completeness and clarity. The device structure or structure 1 of Fig. 1 further comprises structures 400 which are formed during middle-of-line (MOL) and back-end-of-line (BEOL) processes. Those structures 400 will also be illustrated throughout the drawings for illustrative completeness and clarity. However, the transistor structure 200 and the structures 400 will not be described in greater detail.

Further, is it to be understood that the present disclosure is equally applicable to non-stacked semiconductor structures 100, such as non-stacked nanosheet-FET devices and fin-FET devices.

As depicted in Fig. 1, the transistor structure 100 has been formed on a frontside 300a of a substrate 300. The substrate 300 may be a conventional semiconductor substrate suitable for complementary FETs. The substrate 300 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The transistor structure 100 comprises a first S/D body 110 and a second S/D body 120. The first S/D body 110 is located in a first S/D region 115. The second S/D body 120 is located in a second S/D region 125.

The first S/D body 110 and a second S/D body 120 may be formed by epitaxially growing the first S/D body 110 and a second S/D body 120. The first S/D body 110 and the second S/D body 120 may for instance be formed by epitaxially growing doped Si, Si-C, SiGe, Ge, Ge-Sn, or SiGe-Sn.

A channel structure 130 is provided between the first S/D body 110 and the second S/D body 120. The depicted channel structure 130 comprises channel layers 132 in form of nano-sheet channel layers 132. The nano-sheet channel layers 132 depicted in Fig. 1 extends between the first S/D body 110 and the second S/D body 120. In Fig. 1, only two nano-sheet channel layers 132 are illustrated for illustrational clarity although the channel structure 130 may comprise any number of channel layers 132. The channel layers 132 of the channel structure 130 may comprise a high mobility channel material. The channel layers 132 may according to embodiments comprise one or more layers 132 of a Ge-comprising channel material. The channel layers 132 may according to embodiments comprise one or more layers 132 of Ge as the channel material. The channel layers 132 may according to embodiments comprise one or more layers 132 of a SiGe-comprising channel material. In case the channel layers 132 comprise a SiGe-comprising channel material, the Ge concentration may be equal to or above 70% in order to provide a high mobility channel. However, the present disclosure is also applicable for lower Ge concentrations. Similarly, the present disclosure is also applicable for Si-based channel materials.

Further, according to embodiments the channel region 130 may comprise a single channel in channel region. Further, the channel region 130 may comprise channels in form of nanowires.

The depicted channel layers 132 of the channel structure 130 are surrounded by a gate stack 140. The gate stack 140 is schematically drawn and may as is known in the art comprise a gate dielectric and one or more gate metal layers. The gate stack will not be described in greater detail here. However, it is to be understood that any type of suitable gate stack 140 may be used. Further, according to embodiments the gate stack 140 may be provided directly on top of the channel region 130 e.g. in case of a single channel in the channel region 130.

Further, the depicted gate stack 140 is separated from the first S/D body 110 and the second S/D body 120 by an inner spacer 150. The inner spacer 150 which is known per se and may be formed according to known techniques.

The first S/D body 110 and the second S/D body 120 have a first doping concentration. The first doping concentration may lie in the range of 1·10¹⁷ - 1·10²² dopants per cubic centimeter. The first S/D body 110 and the second S/D body 120 may be doped with P, As, Sb, Ga, or B. The first S/D body 110 and the second S/D body 120 may typically be formed simultaneously using the same processing steps to arrive at the first doping concentration.

Now also turning to Fig. 2. Fig. 2 illustrates how the complete structure 1 of Fig. 1 has been bonded to a carrier substrate or wafer 350 by a bonding layer 360. The carrier substrate may be a silicon wafer. The bonding layer may be an oxide or nitride bonding layer, or any other conventional type of bonding layer suitable for CMOS-processing. Further, the complete structure has been flipped upside down such that the substrate 300 which was depicted at the bottom in Fig. 1 is now located at the top as clearly illustrated in Fig. 2. The flipping of the complete structure 1 is also indicated by the altered direction of the Y-axis in Fig. 2 in relation to Fig. 1. By bonding the complete structure 1 of Fig. 1 to the carrier substrate 350 and flipping the complete structure 1, the complete structure 1 is prepared for being subjected to backside processing.

In the following it will be described how the complete structure 1 of Figs. 1 and 2 may be subjected to backside processing subsequent to being subjected to frontside processing. More specifically, it will be described how the first S/D body 110 of the transistor structure 100 may be exposed from a backside 300b of the substrate 300 and how the first S/D body 110 may be processed to form a replacement S/D body 112 in the first S/D region 115, where the replacement S/D body 112 has a second doping concentration which is different from the first doping concentration. In other words, it will in the following be described how the replacement S/D body 112, which has a doping concentration different from the one of the first S/D body 110, is formed in the first S/D region 115 via backside processing of the transistor structure 100. As previously discussed, the first S/D body 110 may define a source body 110 and the second S/D body 120 may define a drain body, wherein a replacement source body 112 with a doping concentration different from (e.g., higher) than the original source body 110 may be formed. However, the first S/D body 110 may also define a drain body 110 and the second S/D body 120 may define a source body, wherein a replacement drain body 112 with a doping concentration different from (e.g., lower) than the original drain body 120 may be formed.

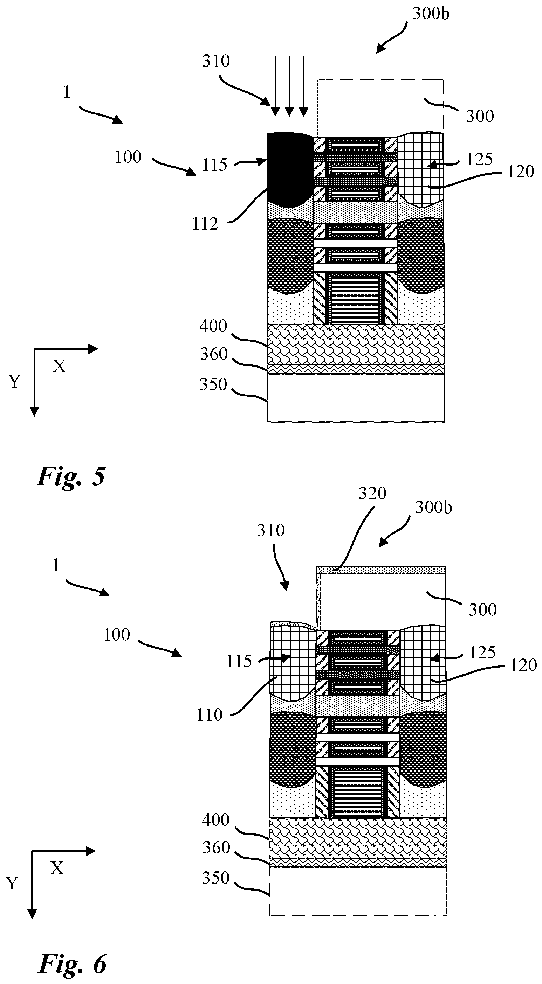

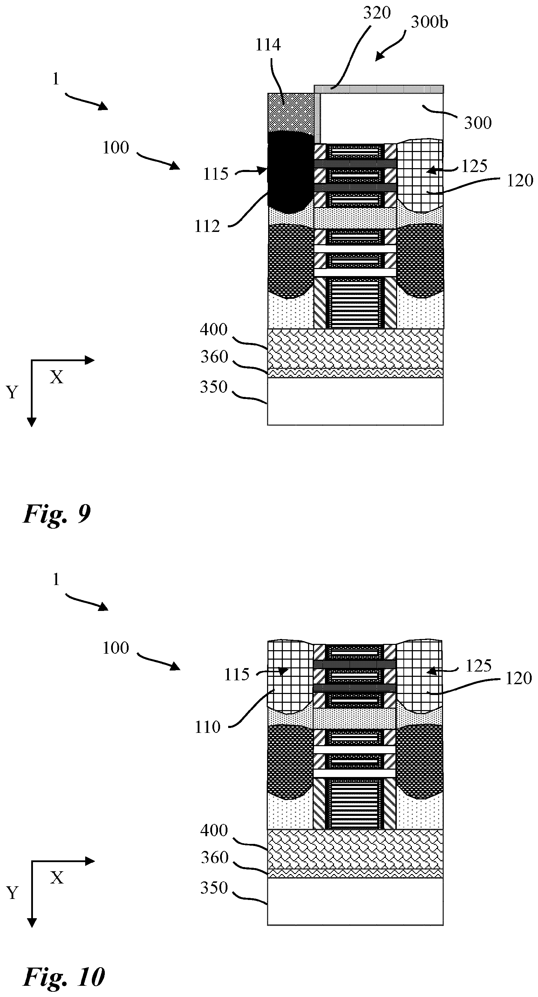

A first approach for forming a replacement S/D body 112 will be disclosed with refence to Fig. 1-5. The first approach does not form part of the present invention but it is useful for its understanding. Followingly, a second approach for forming a replacement S/D body 112 will be disclosed with refence to Fig. 6-8 Thereafter, a third approach for forming a replacement S/D body 112 will be disclosed with refence to Fig. 10-13.

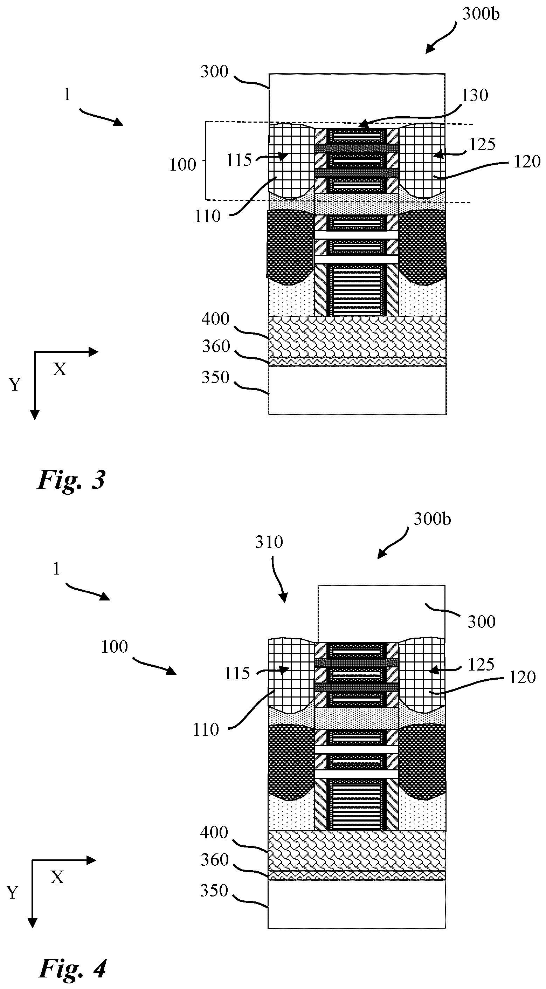

Now also turning to Fig. 3. Fig. 3 illustrates how the substrate 300 has been subjected to thinning from the backside 300b thereof such that only a limited portion of the substrate 300 remains underneath the transistor structure 100. In practice, the substrate 300 may be thinned by grinding or chemical mechanical polishing (CMP), and/or etch back (e.g., anisotropic dry etching, wet etching, a gas chemical etch process like siconi or a certas type of process).

Now also turning to Fig. 4, there is shown that an opening 310 has been formed in the substrate 300. The opening 310 exposes the first S/D body 110 from the backside 300b of the substrate 300 as depicted in Fig. 4. Thus, the opening 310 has been formed in the substrate 300 underneath the first S/D body 110 as illustrated in Fig. 4. The opening 310 may be formed in the substrate by conventional lithographic and etching processes. For instance, a photomask may be formed on the backside of the thinned substrate 300 and used as an etch mask for forming the opening 310 in the substrate 300.

The first S/D body 110 may be processed from the opening 310 to form, the replacement S/D body 112 (see e.g. Fig. 5) in the first S/D region 115. The processing of the first S/D body 110 may, as indicated above, aim at forming the replacement S/D body 112 having a second doping concentration different from the first doping concentration. In this way, an asymmetric transistor structure, i.e. a non-uniform transistor structure with asymmetric source drain doping may be formed.

Fig. 5 illustrates the structure 1 after the first S/D body 110 has been processed to form, in the first S/D region 115, the replacement S/D body 112. More specifically, the replacement S/D body 112 of Fig. 5 has been formed by increasing the doping concentration in the first S/D body 110. In other words, the material of the first S/D body 110 has been modified by increasing the doping concentration in the material of the first S/D body. The doping concentration of the first S/D body 110 may be increased by implanting dopants into the first S/D body 110, and/or by diffusing dopants into the first S/D body 100 as generally indicated by the arrows in Fig. 5. The doping concentration of the first S/D body 110 may be increased by implanting or diffusing P, As, Sb, Ga or B into the first S/D body 100. The doping concentration of the replacement S/D body 112 of Fig. 5 may lie in a part of the range of 1·10¹⁷ - 1·10²² dopants per cubic centimeter above the doping concentration of the first S/D body 110.

Fig. 6 illustrates the structure 1 of Fig. 4 after the structure 1 has been subjected to further processing steps prior to processing the first S/D body 110 to form the replacement S/D body 112. In Fig. 6, an insulating liner 320 covering the substrate and the exposed first S/D body 115 has been formed. The insulating liner 320 may be formed by conformally depositing a dielectric material such as, an insulating oxide or nitride, over the backside 300b of the substrate 300 and over the interior surfaces of the opening 310 including the exposed portions of the exposed first S/D body 110. The insulating liner 320 may include silicon dioxide or silicon nitride.

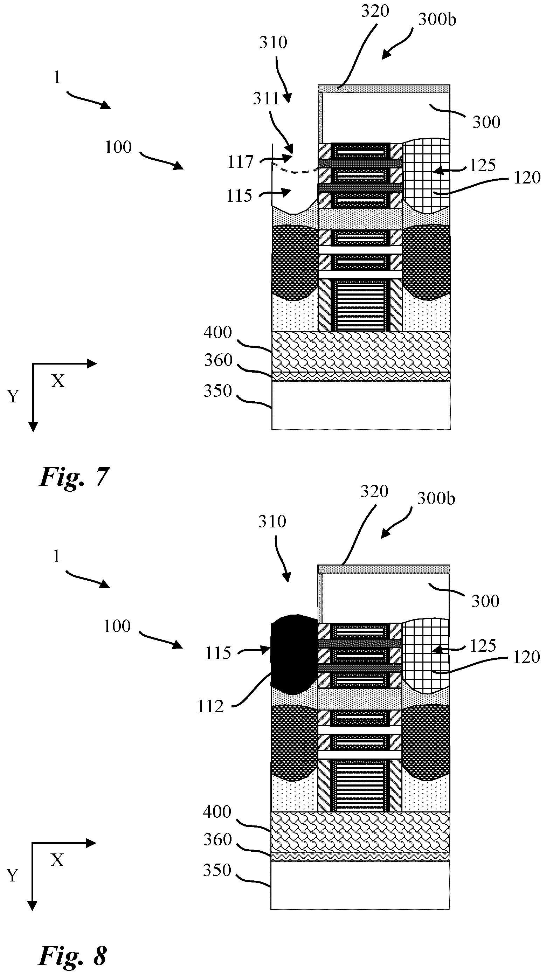

In Fig. 7, the insulating liner 320 has been opened in (i.e., via or from) the opening 310 in the substrate 300, thereby forming an opening 311 in the insulating liner 320. By opening the insulating liner 320 in the opening 310 of the substrate 300, the first S/D body 110 has been exposed via the openings 310 and 311. Part of the insulating liner 320 may be removed by a conventional pattering and etching process. For instance, a patterned resist may be used as an etch mask for opening the insulating liner 320 in the opening 310 of the substrate 300.

Further, in Fig. 7, the first S/D body 110 has been substantially completely removed to form a S/D body cavity 117 the first S/D region 115. According to the invention, at least a major portion of the first S/D body 110 has been removed, to form the S/D body cavity 117 in the first S/D region 115. The at least a major portion of the first S/D body 110 may alternatively be removed as indicated by the hatched line in the S/D body cavity 117 of the first S/D region 115. It is here to be understood that the shape of the hatched line merely is schematic. For instance, the S/D body cavity 117 may instead be formed in a center portion of the first S/D body 110 such that portions of the first S/D body 110 remain adjacent the channel layers 132 and inner spacers 150.

Now also turning to Fig. 8. Fig. 8 illustrates the structure 1 of Fig. 7. However, in Fig. 8, the structure of Fig 7 has been subjected to further processing steps. In Fig. 8, doped S/D material has been epitaxially grown in the first S/D region 115. Hence, doped S/D material has been epitaxially grown via the opening in the insulating liner 320. That is, doped S/D material has been epitaxially grown in the S/D body cavity 117. Hence, the first S/D body has been processed from the opening in the insulating liner 320 to form a replacement S/D body 112 having a second doping concentration which is different from the first doping concentration. In this way, an asymmetric transistor structure, i.e. a non-uniform transistor structure with asymmetric source/drain doping has been formed. The S/D material may be doped with P, As, Sb, Ga or B. The doped S/D material may be grown by chemical vapor deposition (CVD) or atomic layer deposition (ALD) processes. The doping concentration of the replacement S/D body 112 of Fig. 8 may lie in the range of 1·10¹⁷ - 1·10²² dopants per cubic centimeter. The doped S/D material may comprise the same material or materials as the first S/D body but with a different doping concentration.

In case the first S/D body 110 has not been completely removed, and the doped S/D material has been grown on an exposed surface of the first S/D body 110, the formed replacement S/D body 112 will in practice in part be formed of the initial first S/D body 110 and in part be formed of the epitaxially grown doped S/D material. Further, the formed replacement S/D body 112 will have a doping concentration which is different from that of the first S/D body by the doped S/D material having a doping concentration being different from that of the first S/D body.

In Fig. 9 an S/D contact 114 has been formed on the replacement S/D body 112. Hence, the S/D contact 114 has been formed from the backside 300b of the substrate 300. The S/D contact 114 may be formed using conventional methods.

Now also turning to Fig. 10, an alternative way of forming a semiconductor device according to embodiments will be described while starting from structure 1 of Fig. 2. Thus, Fig. 10 illustrates the structure 1 of Fig. 2. However, in Fig. 10, the structure of Fig 2 has been subjected to further processing steps. In Fig. 10 the substrate 300 has been removed underneath the transistor structure 100 to expose the first S/D body 110 and the second S/D body 120. The substrate 300 may be removed underneath the transistor structure 100 using conventional processes including grinding or CMP and/or etching, such as dry etching, wet etching, a gas chemical etch process like siconi or a certas type of process.

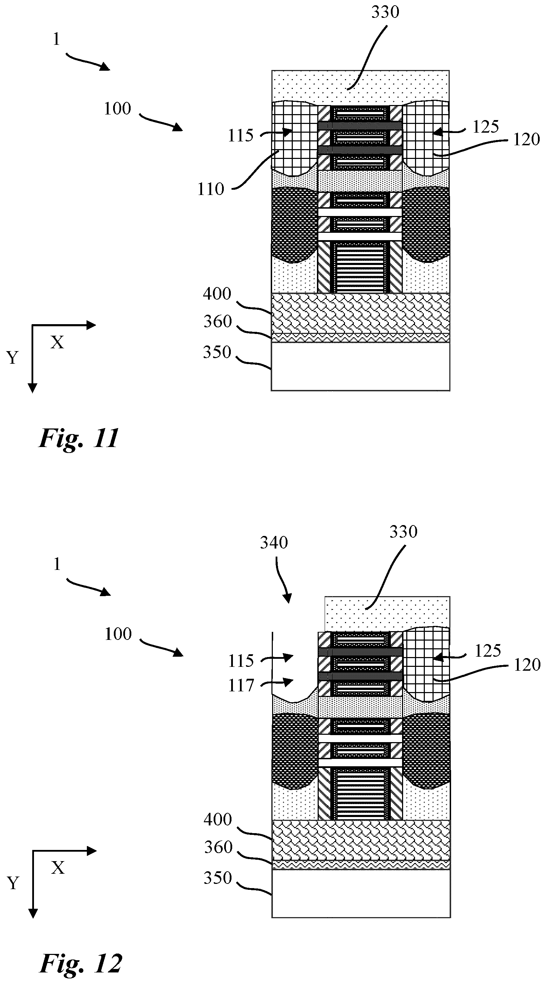

In Fig. 11, a bottom isolation layer 330 covering the first S/D body 110 and the second S/D body 120 has been formed. The bottom isolation layer 330 may be formed by e.g., depositing or growing silicon dioxide or silicon nitride such that the bottom isolation layer 330 covers the first S/D body 110 and the second S/D body as illustrated in Fig. 11. The bottom isolation layer 330 may for instance be formed by CVD, ALD or physical vapor deposition (PVD).

In Fig. 12, an opening 340 has been formed in the bottom isolation layer 330 to expose the first S/D body 110. By forming the opening 340 in the bottom isolation layer 330 the first S/D body 110 has been exposed via the opening 330. The opening 340 in the bottom isolation layer 330 may formed by a conventional pattering and etching process. For instance, a patterned resist may be used as an etch mask for forming the opening 340.

Further, in Fig. 12, the first S/D body 110 has been substantially completely removed. Thus, the removal of the first S/D body may result in that a S/D body cavity 117 is formed. The formation of the S/D body cavity 117 has been described above in conjunction with Fig. 7 to which reference is made. Thus, as described in conjunction with Fig. 7, at least a major portion of the first S/D body 110 is removed, to form the S/D body cavity 117 in the first S/D region 115.

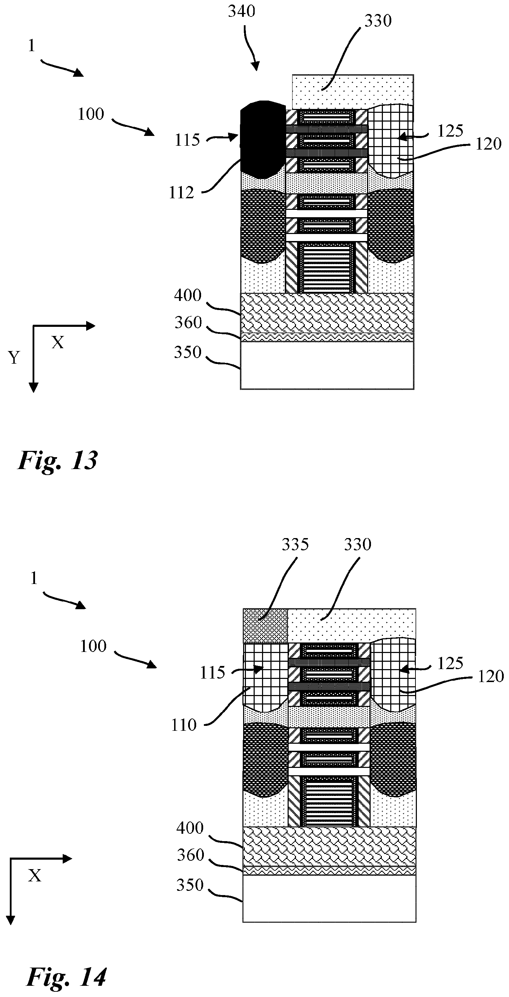

In Fig. 13, the first S/D body 110 has been processed from the opening 340 in the bottom isolation layer 330. More specifically, the first S/D body 110 may be processed as have been described above in conjunction to Fig. 8 to form the replacement S/D body 112 having a second doping concentration which is different from the first doping concentration. Hence, reference is made to the above. Further, an S/D contact 114 may be formed on the replacement S/D body 112 as has been described above in conjunction with Fig. 9.

Now also turning to Fig. 14. Fig. 14 illustrates a structure 1 highly similar to the structure 1 of Fig. 11. However, in Fig. 14, a dummy contact plug 335 is provided underneath the first S/D body 110 as illustrated in Fig. 14. The dummy contact plug 335 of Fig. 14 has been formed during front side processing taking place prior to the backside processing. By the provision of the dummy contact plug, an opening 340 corresponding to the opening 340 of Fig. 11 may be formed by removing the dummy contact plug 335. In other words, the opening 340 in the bottom isolation layer 330 may be formed by removing the dummy contact plug 335 provided underneath the first S/D body 110.

The dummy contact plug 335 may be formed during front side processing prior to forming the transistor structure 100, by e.g. forming a recess in the substrate 300, with a well-controlled overlay with respect to the S/D region 115, and forming the dummy contact plug 335 in the recess. The dummy contact plug 335 may be formed by a dummy material such as amorphous silicon, an epitaxial semiconductor material (e.g., Ge, Si or SiGe), a dielectric material, or more generally any suitable dummy material which may be removed selectively to the bottom isolation layer 330, and which is compatible (e.g., in terms of thermal budget) with the preceding steps of the frontside and backside-processing.

By the provision of the dummy contact plug 335, the opening 340 may be formed in a self-aligned manner with respect to the first S/D body 110.

In case the dummy contact plug 335 is recessed in the substrate 300, an opening 310 may be formed in the substrate 300 by removing the dummy contact plug 335. Hence, an opening 310 may be formed in the substrate as illustrated in Fig. 4. In practice, the formation of such opening 310 may comprise thinning the substrate 300 to expose the dummy contact plug 335 provided underneath the first S/D body 110, and removing the dummy contact plug 335 to expose the first S/D body 110.

Once the opening 310 or the opening 340 has been formed, the structure 1 may be processed as have been described above in conjunction with Figs. 5, 8 or 13 to form the replacement S/D body 112 having a second doping concentration different from the first doping concentration. Further, an S/D contact 114 may be formed on the replacement S/D body 112 as have been described above in conjunction with Fig. 9.

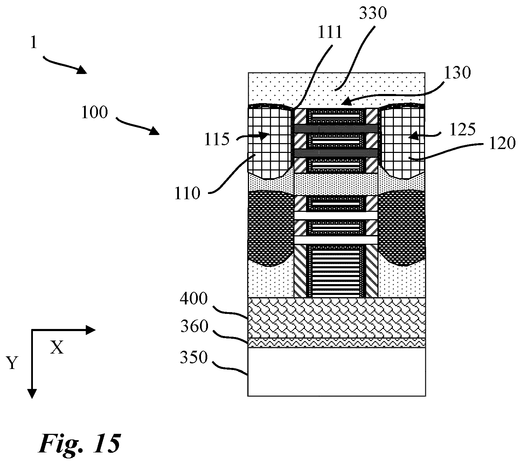

Now also turning to Fig. 15. Fig. 15 illustrates a structure 1 highly similar to the structure 1 of Fig. 11. However, in Fig. 15, the first S/D body 110 comprises a semiconductor liner 111. As illustrated in Fig. 15, the semiconductor liner 111 is provided at least at an interface between the first S/D body 11 and the channel structure 130. The semiconductor liner 111 may be for instance also be provided underneath the first S/D body as illustrated in Fig. 15. The semiconductor liner 111 may be formed of a material different from a material of the first S/D body 110. The semiconductor liner 111 may for instance be formed of silicon or silicon germanium having a low germanium content than the first S/D body 110. In this regard, when the semiconductor liner 111 is formed of silicon germanium the germanium content may typically be lower than a germanium content of the first S/D body 110 in case also the first S/D body is formed of silicon germanium.

By the provision of the semiconductor liner 111 formed of a material different from a material of the first S/D body 110, the first S/D body 110 may be etched selectively with respect to the semiconductor liner 111. In practice, at least a major portion of the first S/D body 110 is removed using an etching process etching the material of the first S/D body selective to the material of the semiconductor liner 111. In this way, a source body cavity 117 corresponding to the source body cavity of Fig. 12 may be formed. Further, by the provision of the semiconductor liner 111 formed of a material different from a material of the first S/D body 110, the removal or partial removal of the first S/D body may be performed with a reduced risk of damaging the channel structure 130. By way of example, the semiconductor liner 111 may be formed by a silicon germanium material with a germanium concentration which differs from the material of the first S/D body by 10% or more (e.g., being at least 10% greater or smaller).

The person skilled in the art realizes that the present invention by no means is limited to the embodiments described above. On the contrary, many modifications and variations are possible within the scope of the appended claims. For example, the replacement S/D body may comprise more than one material or material composition. In this regard, the replacement S/D body may comprise two or more layers having different material compositions. For instance, the replacement S/D body may comprise two or more layers of SiGe with different Ge concentrations. Further, a dummy contact plug 335 may be used in coordination with a first S/D body comprising a semiconductor liner 111. Further, a dummy contact plug 335 may be used in coordination with an insulating layer 320. Furthermore, a S/D contact 114 may be formed on any replacement S/D body 112 described above.

Moreover, after forming the replacement S/D body 112 and a S/D contact 114 in accordance with any of the above described approaches, additional backside processing steps may be applied to the structure 10. For instance, the method may proceed with forming a backside interconnect structure for routing signals or power to the transistor structure 100, e.g. via the S/D contact 114, and to any further devices (e.g., CFETs) of the device structure 1. A backside interconnect structure may be formed using conventional techniques used in the BEOL for forming frontside interconnect structures, such as damascene processing. The specific layout and details of the backside interconnect structure are beyond the scope of the present methods and will hence not be further discussed herein.

## Claims

1. A method for forming a semiconductor device, comprising:
performing frontside processing comprising forming a transistor structure (100) on a frontside (300a) of a substrate (300), the transistor structure (100) comprising a first source/drain body (110) and a second source/drain (120) body located in a first and a second source/drain region (115, 125), respectively, and a channel structure (130) between the first source/drain body (110) and the second source/drain body (120), wherein the first source/drain body (110) and the second source/drain body (120) have a first doping concentration;
subsequent to the frontside processing, performing backside processing comprising:
exposing the first source/drain body (110) from a backside (300b) of the substrate (300); and
processing the first source/drain body (110) to form, in the first source/drain region (115), a replacement source/drain body (112) having a second doping concentration different from the first doping concentration, while not affecting the first doping concentration of the second source/drain body (120) in the second source/drain region (125) to form a non-uniform transistor structure (100) with an asymmetric source drain doping,
**characterized in that**
the processing the first source/drain body (110) to form, in the first source/drain region (115), the replacement source/drain body (112) having the second doping concentration different from the first doping concentration comprises the steps of:
removing at least a major portion of the first source/drain body (110), to form a source/drain body cavity (117) in the first source/drain region (115), and
subsequently epitaxially growing doped source/drain material in the source/drain body cavity (117).

2. The method according to claim 1, wherein the doped source/drain material is grown on an exposed surface of the first source/drain body (110).

3. The method according to claim 1 or 2, wherein the first source/drain body (110) comprises a semiconductor liner (111) provided at least at an interface between the first source/drain body (110) and the channel structure (130), wherein the semiconductor liner (111) is formed of a material different from a material of the first source/drain body (110).

4. The method according to claim 3 wherein the at least a major portion of the first source/drain body (110) is removed using an etching process etching the material of the first source/drain body (110) selective to the material of the semiconductor liner (111).

5. The method according to any one of the preceding claims, wherein exposing the first source/drain body (110) comprises thinning the substrate (300) from the backside (300b).

6. The method according to any one of the preceding claims, wherein exposing the first source/drain body (110) comprises forming an opening (310) in the substrate (300) underneath the first source/drain body (110) to expose the first source/drain body (110), wherein the first source/drain body (110) is processed from the opening (310) in the substrate (300).

7. The method according to claim 6, further comprising:
subsequent to forming the opening (310) in the substrate (300), forming an insulating liner (320) covering the substrate (300) and the exposed first source/drain body (110); and
opening the insulating liner (320) in the opening (310) in the substrate (300) to expose the first source/drain body (110),
wherein the first source/drain body (110) is processed from the opening in the insulating liner (320).

8. The method according to claim 7 wherein the doped source/drain material is epitaxially grown via the opening in the insulating liner (320).

9. The method according to claim 8 wherein the at least a major portion of the first source/drain body (110) is removed by etching from the opening in the insulating liner (320).

10. The method according to any one of claims 1-5, wherein exposing the first source/drain body (110) comprises:
removing the substrate (300) underneath the transistor structure (100) to expose the first source/drain body (110) and the second source/drain body (120);
forming a bottom isolation layer (330) covering the first source/drain body (110) and the second source/drain body (120); and
forming an opening (340) in the bottom isolation layer (330) to expose the first source/drain body (110);
wherein the first source/drain body (110) is processed from the opening (340) in the bottom isolation layer (330).

11. The method according to any one of claims 1-5, wherein exposing the first source/drain body (110) comprises:
thinning the substrate (300) to expose a dummy contact plug (335) in a bottom isolation layer (330), wherein the dummy contact plug (335) is provided underneath the first source/drain body (110), and
removing the dummy contact plug (335) to expose the first source/drain body (110).

12. The method according to any one of the preceding claims, wherein the method further comprises:
forming a source/drain contact (114) on the replacement source/drain body (112).

## Patentansprüche

1. Verfahren zum Bilden eines Halbleiterbauelements, umfassend:
Ausführen einer Vorderseitenverarbeitung, die das Bilden einer Transistorstruktur (100) auf einer Vorderseite (300a) eines Substrats (300) umfasst, wobei die Transistorstruktur (100) einen ersten Source-/Drain-Körper (110) und einen zweiten Source-/Drain-Körper (120), die sich jeweils in einem ersten und einem zweiten Source-/Drain-Bereich (115, 125) befinden, und eine Kanalstruktur (130) zwischen dem ersten Source-/Drain-Körper (110) und dem zweiten Source-/Drain-Körper (120) umfasst, wobei der erste Source-/Drain-Körper (110) und der zweite Source-/Drain-Körper (120) eine erste Dotierungskonzentration aufweisen;
anschließend an die Vorderseitenverarbeitung, Ausführen einer Rückseitenverarbeitung, umfassend:
Freilegen des ersten Source-/Drain-Körpers (110) von einer Rückseite (300b) des Substrats (300) aus; und
Verarbeiten des ersten Source-/Drain-Körpers (110), um in dem ersten Source-/Drain-Bereich (115) einen Ersatz-Source-/Drain-Körper (112) zu bilden, der eine zweite Dotierungskonzentration, die anders als die erste Dotierungskonzentration ist, aufweist, aber dabei die erste Dotierungskonzentration des zweiten Source-/Drain-Körpers (120) in dem zweiten Source-/Drain-Bereich (125) nicht beeinträchtigt, um eine uneinheitliche Transistorstruktur (100) mit einer asymmetrischen Source-/Drain-Dotierung zu bilden,
**dadurch gekennzeichnet, dass** die Verarbeitung des ersten Source-/Drain-Körpers (110), um in dem ersten Source-/Drain-Bereich (115) den Ersatz-Source-/Drain-Körper (112) zu bilden, der die zweite Dotierungskonzentration, die anders als die erste Dotierungskonzentration ist, aufweist, die folgenden Schritte umfasst:
Entfernen mindestens eines Hauptanteils des ersten Source-/Drain-Körpers (110), um einen Source-/Drain-Körperhohlraum (117) in dem ersten Source-/Drain-Bereich (115) zu bilden, und
anschließendes epitaktisches Ziehen von dotiertem Source-/Drain-Material in dem Source-/Drain-Körperhohlraum (117).

2. Verfahren nach Anspruch 1, wobei das dotierte Source-/Drain-Material auf einer freigelegten Oberfläche des ersten Source-/Drain-Körpers (110) gezogen wird.

3. Verfahren nach Anspruch 1 oder 2, wobei der erste Source-/Drain-Körper (110) eine Halbleiterauskleidung (111) umfasst, die mindestens an einer Schnittstelle zwischen dem ersten Source-/Drain-Körper (110) und der Kanalstruktur (130) bereitgestellt wird, wobei die Halbleiterauskleidung (111) aus einem anderen Material als einem Material des ersten Source-/Drain-Körpers (110) gebildet wird.

4. Verfahren nach Anspruch 3, wobei der mindestens eine Hauptanteil des ersten Source-/Drain-Körpers (110) unter Verwendung eines Ätzprozesses, der das Material des ersten Source-/Drain-Körpers (110) gegenüber dem Material der Halbleiterauskleidung (111) selektiv ätzt, entfernt wird.

5. Verfahren nach einem der vorhergehenden Ansprüche, wobei das Freilegen des ersten Source-/Drain-Körpers (110) das Verdünnen des Substrats (300) von der Rückseite (300b) aus umfasst.

6. Verfahren nach einem der vorhergehenden Ansprüche, wobei das Freilegen des ersten Source-/Drain-Körpers (110) das Bilden einer Öffnung (310) in dem Substrat (300) unterhalb des ersten Source-/Drain-Körpers (110) umfasst, um den ersten Source-/Drain-Körper (110) freizulegen, wobei der erste Source-/Drain-Körper (110) von der Öffnung (310) in dem Substrat (300) aus verarbeitet wird.

7. Verfahren nach Anspruch 6, ferner umfassend:
anschließend an das Bilden der Öffnung (310) in dem Substrat (300), Bilden einer Isolierauskleidung (320), die das Substrat (300) und den freigelegten ersten Source-/Drain-Körper (110) abdeckt; und
Öffnen der Isolierauskleidung (320) in der Öffnung (310) in dem Substrat (300), um den ersten Source-/Drain-Körper (110) freizulegen,
wobei der erste Source-/Drain-Körper (110) von der Öffnung in der Isolierauskleidung (320) aus verarbeitet wird.

8. Verfahren nach Anspruch 7, wobei das dotierte Source-/Drain-Material über die Öffnung in der Isolierauskleidung (320) epitaktisch gezogen wird.

9. Verfahren nach Anspruch 8, wobei der mindestens eine Hauptanteil des ersten Source-/Drain-Körpers (110) durch Ätzen von der Öffnung in der Isolierauskleidung (320) aus entfernt wird.

10. Verfahren nach einem der Ansprüche 1 bis 5, wobei das Freilegen des ersten Source-/Drain-Körpers (110) umfasst:
Entfernen des Substrats (300) unterhalb der Transistorstruktur (100), um den ersten Source-/Drain-Körper (110) und den zweiten Source-/Drain-Körper (120) freizulegen;
Bilden einer unteren Isolierschicht (330), die den ersten Source-/Drain-Körper (110) und den zweiten Source-/Drain-Körper (120) abdeckt; und
Bilden einer Öffnung (340) in der unteren Isolierschicht (330), um den ersten Source-/Drain-Körper (110) freizulegen;
wobei der erste Source-/Drain-Körper (110) von der Öffnung (340) in der unteren Isolierschicht (330) aus verarbeitet wird.

11. Verfahren nach einem der Ansprüche 1 bis 5, wobei das Freilegen des ersten Source-/Drain-Körpers (110) umfasst:
Verdünnen des Substrats (300), um einen Dummy-Steckkontakt (335) in einer unteren Isolierschicht (330) freizulegen, wobei der Dummy-Steckkontakt (335) unterhalb des ersten Source-/Drain-Körpers (110) bereitgestellt wird, und
Entfernen des Dummy-Steckkontakts (335), um den ersten Source-/Drain-Körper (110) freizulegen.

12. Verfahren nach einem der vorhergehenden Ansprüche, wobei das Verfahren ferner umfasst:
Bilden eines Source-/Drain-Kontakts (114) an dem Ersatz-Source-/Drain-Körper (112).

## Revendications

1. Procédé de formation d'un dispositif semiconducteur, comprenant :
l'exécution d'un traitement de face avant comprenant la formation d'une structure de transistor (100) sur une face avant (300a) d'un substrat (300), la structure de transistor (100) comprenant un premier corps de source/drain (110) et un deuxième corps de source/drain (120) situés dans une première et une deuxième région de source/drain (115, 125), respectivement, et une structure de canal (130) entre le premier corps de source/drain (110) et le deuxième corps de source/drain (120), dans lequel le premier corps de source/drain (110) et le deuxième corps de source/drain (120) ont une première concentration de dopage ;
à la suite du traitement de face avant, l'exécution d'un traitement de face arrière comprenant :
l'exposition du premier corps de source/drain (110) à partir d'une face arrière (300b) du substrat (300) ; et
le traitement du premier corps de source/drain (110) pour former, dans la première région de source/drain (115), un corps de source/drain de remplacement (112) ayant une deuxième concentration de dopage différente de la première concentration de dopage, tout en n'affectant pas la première concentration de dopage du deuxième corps de source/drain (120) dans la deuxième région de source/drain (125) afin de former une structure de transistor non uniforme (100) avec un dopage de source drain asymétrique,
**caractérisé en ce que**
le traitement du premier corps de source/drain (110) pour former, dans la première région de source/drain (115), le corps de source/drain de remplacement (112) ayant la deuxième concentration de dopage différente de la première concentration de dopage comprend les étapes de :
retrait d'au moins une majeure partie du premier corps de source/drain (110), pour former une cavité de corps de source/drain (117) dans la première région de source/drain (115) et
ensuite, croissance épitaxiale du matériau de source/drain dopé dans la cavité de corps de source/drain (117).

2. Procédé selon la revendication 1, dans lequel la croissance du matériau de source/drain dopé a lieu sur une surface exposée du premier corps de source/drain (110).

3. Procédé selon la revendication 1 ou 2, dans lequel le premier corps de source/drain (110) comprend un revêtement semiconducteur (111) prévu au moins au niveau d'une interface entre le premier corps de source/drain (110) et la structure de canal (130), dans lequel le revêtement semiconducteur (111) est constitué d'un matériau différent d'un matériau du premier corps de source/drain (110).

4. Procédé selon la revendication 3, dans lequel au moins une majeure partie du premier corps de source/drain (110) est retirée en utilisant un processus de gravure par attaque chimique gravant par attaque chimique le matériau du premier corps de source/drain (110) sélectivement vis-à-vis du matériau du revêtement semiconducteur (111).

5. Procédé selon une quelconque des revendications précédentes, dans lequel l'exposition du premier corps de source/drain (110) comprend l'amincissement du substrat (300) à partir de la face arrière (300b).

6. Procédé selon une quelconque des revendications précédentes, dans lequel l'exposition du premier corps de source/drain (110) comprend la formation d'une ouverture (310) dans le substrat (300) au-dessous du premier corps de source/drain (110) afin d'exposer le premier corps de source/drain (110), dans lequel le premier corps de source/drain (110) est traité à partir de l'ouverture (310) dans le substrat (300).

7. Procédé selon la revendication 6, comprenant en outre :
à la suite de la formation de l'ouverture (310) dans le substrat (300), la formation d'un revêtement isolant (320) recouvrant le substrat (300) et le premier corps de source/drain exposé (110) ; et
l'ouverture du revêtement isolant (320) dans l'ouverture (310) dans le substrat (300) afin d'exposer le premier corps de source/drain (110),
dans lequel le premier corps de source/drain (110) est traité à partir de l'ouverture dans le revêtement isolant (320).

8. Procédé selon la revendication 7, dans lequel la croissance épitaxiale du matériau de source/drain dopé a lieu via l'ouverture dans le revêtement isolant (320).

9. Procédé selon la revendication 8, dans lequel au moins une majeure partie du premier corps de source/drain (110) est retirée par gravure par attaque chimique à partir de l'ouverture dans le revêtement isolant (320).

10. Procédé selon une quelconque des revendications 1 à 5, dans lequel l'exposition du premier corps de source/drain (110) comprend :
le retrait du substrat (300) au-dessous de la structure de transistor (100) afin d'exposer le premier corps de source/drain (110) et le deuxième corps de source/drain (120) ;
la formation d'une couche d'isolation inférieure (330) recouvrant le premier corps de source/drain (110) et le deuxième corps de source/drain (120) ; et
la formation d'une ouverture (340) dans la couche d'isolation inférieure (330) afin d'exposer le premier corps de source/drain (110) ;
dans lequel le premier corps de source/drain (110) est traité à partir de l'ouverture (340) dans la couche d'isolation inférieure (330).

11. Procédé selon une quelconque des revendications 1 à 5, dans lequel l'exposition du premier corps de source/drain (110) comprend :
l'amincissement du substrat (300) afin d'exposer une fiche de contact aveugle (335) dans une couche d'isolation inférieure (330), dans lequel la fiche de contact aveugle (335) est prévue au-dessous du premier corps de source/drain (110) et
le retrait de la fiche de contact aveugle (335) afin d'exposer le premier corps de source/drain (110).

12. Procédé selon une quelconque des revendications précédentes, dans lequel le procédé comprend en outre : la formation d'un contact de source/drain (114) sur le corps de source/drain de remplacement (112).
